# EUROPÄISCHE PATENTANMELDUNG

(11) **EP 1 858 312 A2**
(43) Veröffentlichungstag der Anmeldung: **21.11.2007**
(21) Anmeldenummer: 07007659.1
(22) Anmeldetag: 14.04.2007
(51) Int. Cl.: H05K 5/06

(54) **Elektronische Baueinheit**

(30) Priorität: 26.04.2006 DE 102006019250
(71) Anmelder: Robert Bosch GmbH, 70184 Stuttgart (DE)
(72) Erfinder: Vagt, Hans-Joachim, 89073 Ulm (DE)

(57) **Zusammenfassung**

Eine elektronische Baueinheit, die sich insbesondere zum Einsatz in einem ölgefüllten bzw. druckbeaufschlagten Innenraum einer Hydraulikeinheit eignet, ist mit einer Leiterplatte, mit einer Beschaltung der Leiterplatte, die Leiterbahnabschnitte und in einem Gehäuseabschnitt der Leiterplatte angeordnete elektronische Bauelemente umfasst, und mit einem Leiterplattenfortsatz, der an einem dem Gehäuseabschnitt abgewandten Kontaktabschnitt elektrische Kontaktflächen aufweist, ausgestattet. Die Beschaltung der Leiterplatte ist durch Leiterplattenmaterial flüssigkeitsdicht abgedeckt.

## Beschreibung

Die Erfindung betrifft eine elektronische Baueinheit, insbesondere zum Einsatz in einem ölgefüllten bzw. druckbeaufschlagten Innenraum einer Hydraulikeinheit.

Bei einer Vielzahl von Komponenten eines hydraulischen Systems, den Hydraulikeinheiten, z.B. Proportionalventilen, Verstellpumpen, Drucksensoren, usw., ist es wünschenswert, Zustandsgrößen im Innern der Hydraulikeinheit zu erfassen und an eine an der Hydraulikeinheit befestigten Elektronik weiterzugeben. Solche Zustandsgrößen sind z.B. die Auslenkung eines Ventilkolbens oder der Schwenkwinkel einer Axialkolbenpumpe.

Des Weiteren werden immer mehr Hydraulikeinheiten mit einer so genannten "On Board Elektronik" ausgestattet, also einer Ansteuerelektronik, die die Ansteuerung der Hydraulikeinheit über Leistungsverstärker und gegebenenfalls auch Regelfunktionen oder Steuerfunktionen ausführt. Eine Hydraulikeinheit mit On Board Elektronik zeichnet sich durch einen geringen Konfigurationsaufwand bei der Montage aus und ist über eine standardisierte Schnittstelle ansprechbar.

Im Zuge der Miniaturisierung wäre es wünschenswert, möglichst die gesamte Elektronik innerhalb der Hydraulikeinheit anzuordnen. Dies erfordert jedoch ein aufwendig abgedichtetes Gehäuse für die Elektronik, insbesondere im Bereich der Durchführung von Zuleitungen durch die Gehäusewand. Zudem bauen entsprechend druckfeste bzw. gegen Druckmittel resistente Gehäuse relativ groß und sind daher im Innern einer Hydraulikeinheit nicht einsetzbar.

Es ist die Aufgabe der vorliegenden Erfindung, eine verbesserte elektronische Baueinheit anzugeben, die sich insbesondere für den Einsatz in einem ölgefüllten bzw. druckbeaufschlagten Innenraum einer Hydraulikeinheit eignet.

Diese Aufgabe wird durch eine elektronische Baueinheit mit den Merkmalen des Patentanspruchs 1 gelöst.

Die erfindungsgemäße elektronische Baueinheit ist mit einer Leiterplatte, mit einer Beschaltung der Leiterplatte, die Leiterbahnabschnitte und in einem Gehäuseabschnitt der Leiterplatte angeordnete elektronische Bauelemente umfasst, und mit einem Leiterplattenfortsatz, der an einem dem Gehäuseabschnitt abgewandten Kontaktabschnitt elektrische Kontaktflächen aufweist, ausgestattet. Die Beschaltung der Leiterplatte ist durch Leiterplattenmaterial flüssigkeitsdicht abgedeckt.

Die Besonderheit der vorliegenden Erfindung ist es also, dass aus Leiterplattenmaterial ein flüssigkeitsdichtes Gehäuse mit einem davon abstehenden Leiterplattenfortsatz für den elektrischen Anschluss gebildet wird. Das durch die Leiterplatte und ihre Abdeckung gebildete Gehäuse ist stabil und druckfest. Es kann ohne Weiteres mechanisch bearbeitet werden, z.B. um Befestigungsbohrungen anzubringen. Die Verwendung von Leiterplattenmaterial ermöglicht eine hohe chemische Beständigkeit, insbesondere gegenüber Mineralölen, wie sie üblicherweise als Druckflüssigkeit zum Einsatz kommen. Der Leiterplattenfortsatz geht als Bestandteil der Leiterplatte nahtlos in den Gehäuseabschnitt über, ohne dass die Abdeckung der Beschaltung durch einen Materialübergang unterbrochen ist. Dadurch vermeidet man Spalte, die an Materialübergängen zwischen z.B. einer metallischen Leiterbahn und Kunstharz auftreten können und erzielt so eine äußerst zuverlässige Abdichtung der elektronischen Baueinheit. Die erfindungsgemäße elektronische Baueinheit schützt die darin angeordneten Bauelemente daher insbesondere auch gegen eine wechselnde Druckbeanspruchung. Der Leiterplattenfortsatz ist bei geringer Materialstärke und/oder bei geeigneter Wahl des Leiterplattenmaterials flexibel und kann vergleichbar einem Kabel aus dem Innenraum der Hydraulikeinheit herausgeführt werden. Gemäß der vorliegenden Erfindung können somit kompakte elektronische Baueinheiten realisiert werden, deren Beschaltung im Innenraum der Hydraulikeinheit vollständig mit Leiterplattenmaterial abgedeckt ist und die nur im Außenbereich der Hydraulikeinheit - z.B. am Kontaktabschnitt - eine Durchbrechung der Abdeckung aufweisen. Die erfindungsgemäße elektronische Baueinheit lässt sich innerhalb bestehender Leiterplattenherstellungs- und Leiterplattenbestückungsprozesse einfach herstellen. Es stehen für die Gestaltung der Baueinheit prinzipiell eine Vielzahl der in der Leiterplattentechnik üblichen Aufbauvarianten zur Verfügung. Dies umfasst z.B. das Vorsehen von Einlagekörpern aus Metall, Glasfasern, Kunstfasern oder Keramik zur Erhöhung der Druckfestigkeit, Stabilität und Biegesteifigkeit und/oder zur Verbesserung der Entwärmung. Durch den Wegfall eines separaten Gehäuses und von Abdichtungen erlaubt die vorliegender Erfindung eine kostengünstige Herstellung der elektronischen Baueinheit. Die Leiterplatte kann vollständig in hydraulisches Druckmittel eingetaucht werden und ermöglicht so die effiziente Kühlung der elektronischen Beschaltung.

Vorteilhafte Ausgestaltungen der vorliegenden Erfindung sind in den Unteransprüchen angegeben.

Vorzugsweise weist die Leiterplatte mehrere übereinander aufgebrachte Leiterplattenschichten auf. Die Fertigung kann einschließlich der Bestückung und Kontaktierung der elektronischen Bauelemente analog zur Fertigung einer Standardleiterplatte erfolgen. Anschließend wird die Leiterplatte um eine Abdeckschicht aus Leiterplattenmaterial ergänzt, so dass ein Gehäuse gebildet wird. Auf diese Weise können auch Leiterplatten, die auf mehreren Schichten elektronische Bauelemente tragen, gefertigt werden. Die Abdeckschicht wird in einem abschließenden Arbeitsgang aufgebracht. Die übereinander aufgebrachten Leiterplattenschichten ermöglichen eine dichte und stabile chemische Verbindung aller eingesetzten Materialien und Bauelemente.

Eine besonders einfache Herstellung erreicht man, wenn die Leiterplattenschichten miteinander verklebt sind. Auf diese Weise können vollständig bestückte Leiterplattenschichten vorgefertigt werden und in einem abschließenden Arbeitsgang zu einer Mehrschicht-Leiterplatte verklebt werden, die gleichzeitig das Gehäuse der elektronischen Baueinheit darstellt. Dies vereinfacht die Herstellung und Bestückung der Leiterplatte unter Ausnutzung bestehender Fertigungsprozesse. Werden elektronische Bauelemente mit niedriger Bauhöhe verwendet - z.B. SMD Elemente -, so können diese in die Klebeschicht eingebettet werden.

Gemäß einer besonders bevorzugten Ausgestaltung der vorliegenden Erfindung ist der Leiterplattenfortsatz mittels zweier übereinander angeordneter Leiterplattenschichten der Leiterplatte gebildet. Dabei bildet eine der Leiterplattenschichten eine Trägerschicht für den Leiterplattenfortsatz. Darauf sind Leiterbahnen angeordnet. Die zweite Leiterplattenschicht bildet eine Abdeckschicht des Leiterplattenfortsatzes. Dies erlaubt es, auf einfache Weise den Leiterplattenfortsatz an den Gehäuseabschnitt der Leiterplatte nahtlos anzubinden. Durch eine Ausbildung des Leiterplattenfortsatzes aus nur zwei Leiterplattenschichten kann ein besonders niedriges Profil und eine gute Biegbarkeit des Leiterplattenfortsatzes gewährleistet werden.

Vorzugsweise umfassen Leiterplattenschichten im Leiterplattenfortsatz eine Polyesterfolie, insbesondere eine Polyimidfolie. Dabei handelt es sich um ein bewährtes Material für flexible Leiterplatten. Somit wird eine besonders gute Biegbarkeit bei guter Stabilität des Leiterplattenfortsatzes erzielt.

Gemäß einer weiteren bevorzugten Ausgestaltung weisen in der Leiterplatte angeordnete Einlagen, insbesondere eine Glasfaserverstärkung, eine abdeckende Beschichtung an einer Außenseite der elektronischen Baueinheit auf. Bei Verwendung einer Glasfaserverstärkung erhält man eine mechanisch hoch belastbare Leiterplatte. Der Kapillareffekt, aufgrund dessen entlang der Glasfasern Druckmittel in die Leiterplatte eindringen könnte, wird wirksam unterbunden. Auch bei Einlagen aus Metall oder Keramik, die bündig mit der Außenseite abschließen, verhindert die Abdeckbeschichtung ein Eindringen von Flüssigkeit entlang der Materialübergangsspalte. Als Beschichtungsmaterial kann z.B. Epoxydharz verwendet werden.

Vorzugsweise umfasst die Beschaltung der Leiterplatte einen berührungslos arbeitenden Sensor, insbesondere einen Hallsensor, einen kapazitiven Annäherungssensor, einen optischen Sensor oder einen induktiv arbeitenden Sensor. Durch solche Sensoren können Zustände im Inneren der Hydraulikeinheit erfasst werden, ohne dass bewegliche Bauteile oder elektrische Kontakte an der Außenseite des Gehäuseabschnitts der elektronischen Baueinheit vorhanden sind. Dadurch sind Abdichtungsprobleme von vornherein ausgeschlossen. Durch einen Hallsensor können z.B. Schaltstellungen eines Ventils erfasst werden. Bei einem durchsichtigen Leiterplattenmaterial kann dazu ebenso ein im Innern der Leiterplatte angeordneter optischer Sensor verwendet werden. Ein kapazitiver Annäherungssensor, ein optischer Sensor oder ein induktiver Sensor lassen sich z.B. als Bestandteil eines Wegmesssystems in einem Ventil oder einem Zylinder vorsehen.

Wenn mittlere Leiterplattenschichten Aussparungen aufweisen, in denen elektronische Bauelemente aufgenommen sind, lassen sich auch größere Bauelemente problemlos in die elektronische Baueinheit integrieren. Die Aussparungen können nach Einsetzen der Bauelemente zur Verbesserung der Stabilität und der thermischen Anbindung der Bauelemente an die Leiterplatte mit einer geeigneten Vergussmasse aufgefüllt werden.

Gemäß einer weiteren bevorzugten Ausbildung der vorliegenden Erfindung weist der Leiterplattenfortsatz an einem Durchführungsabschnitt eine aus Leiterplattenmaterial gebildete Verdickung auf. Dadurch kann eine bessere bzw. einfachere Abdichtung einer Durchführung des Leiterplattenfortsatzes an einem Gehäuse einer Hydraulikeinheit erzielt werden. Die Verdickung erhöht die Formstabilität des Leiterplattenfortsatzes im Bereich des Durchführungsabschnittes. Dadurch kann der Durchführungsabschnitt des Leiterplattenfortsatzes bei niedriger Druckbelastung selbst als Dichtelement dienen. Ein solcher Durchführungsabschnitt lässt sich außerdem durch eine senkrecht zur Längsrichtung des Leiterplattenfortsatzes ausgerichtete Anlagefläche abstützen. Außerdem lässt sich die Oberfläche des verdickten Durchführungsabschnittes strukturieren oder aufrauen, um die Haftung eines daran anliegenden oder angespritzten Dichtelements zu verbessern. Es wird darauf hingewiesen, dass eine Verdickung eines Leiterplattenfortsatzes bzw. eines Leiterfolienschwanzes im Bereich einer abgedichteten Durchführung schon für sich alleine als vorteilhaft erachtet wird. Die Merkmale des Anspruchs 1 werden im Hinblick auf die Ausbildung der Dichtung als optional angesehen.

Nachfolgend werden die vorliegende Erfindung und deren Vorteile unter Bezugnahme auf das in den Figuren dargestellte Ausführungsbeispiel näher erläutert.
- Figur 1: zeigt eine Seitenansicht einer elektronischen Baueinheit, die im Innern einer Hydraulikeinheit befestigt ist, im Teilschnitt und
- Figur 2: zeigt die in Figur 1 dargestellte elektronische Baueinheit in Aufsicht.

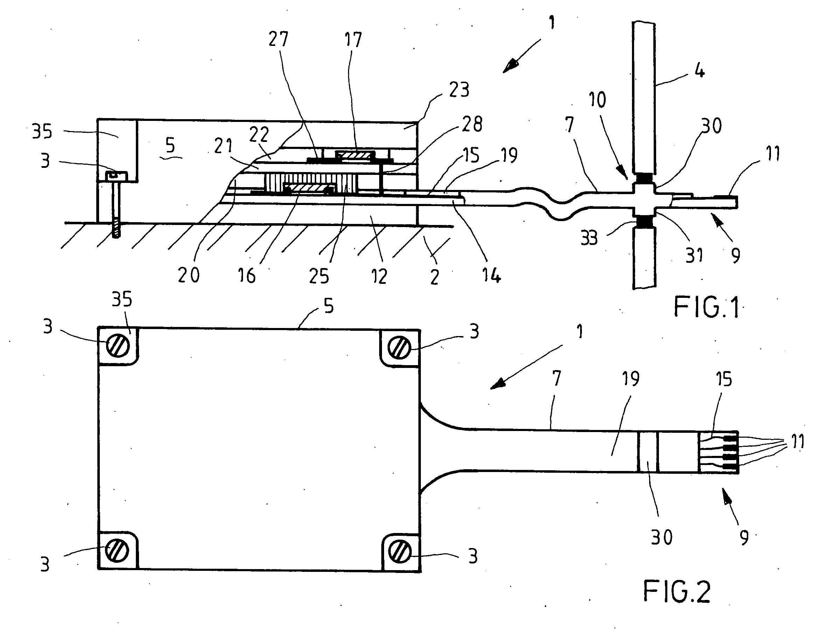

Nach Figur 1 und Figur 2 ist im Innern einer Hydraulikeinheit die elektronische Baueinheit 1 auf einer geeigneten Unterlage 2 durch Schrauben 3 befestigt. Die elektronische Baueinheit 1 besitzt einen Gehäuseabschnitt 5 sowie einen Leiterplattenfortsatz 7. Der Leiterplattenfortsatz 7 ist durch eine Gehäusewand 4 der Hydraulikeinheit nach außen geführt. Dort besitzt er einen Kontaktabschnitt 9 auf dem elektrische Kontaktflächen 11 angeordnet sind.

Im Bereich der Durchführung 10 ist am Leiterplattenfortsatz 7 eine Verdickung 30 und 31 aus Leiterplattenmaterial gebildet. Dieses ist als zusätzliche Schicht auf das Leiterplattenmaterial, das den Leiterplattenfortsatz 7 bildet, oben und unten aufgebracht. Die Verdickung 30 und 31 sorgt für eine hohe Formstabilität des Leiterplattenfortsatzes 7 im Bereich der Durchführung 10. Die Verdickung kann alleine als Dichtelement dienen, wenn die Druckbelastung niedrig ist. Die Oberfläche an der Verdickung 30 und 31 lässt sich strukturieren oder aufrauen, um eine innigere Verbindung mit einem anliegenden oder angespritzten Dichtelement 33 zu gewährleisten. Dies wäre bei herkömmlichen Leiterfolienschwänzen aufgrund der geringen Materialstärke nicht möglich. Der Leiterplattenfortsatz 7 lässt sich an der Verdickung 30 und 31 zusätzlich durch eine an der Gehäusewand 4 senkrecht zur Längsrichtung des Leiterplattenfortsatzes 7 gebildeten Anlagefläche (nicht dargestellt) abstützen. Dadurch lässt sich unter Anderem eine Zugentlastung realisieren, die gegen von außen einwirkende Zugkräfte bzw. gegen von innerhalb der Gehäusewand 4 einwirkende Druckkräfte wirksam ist.

Der Gehäuseabschnitt 5 sitzt mit einer Trägerschicht 12 aus Leiterplattenmaterial auf der Unterlage 2 auf. Auf der Trägerschicht 12 ist eine weitere Leiterplattenschicht 14 aufgebracht. Die Leiterplattenschicht 14 steht an der rechten Seite des Gehäuseabschnitts 5 über die Trägerschicht 12 vor und bildet eine untere Schicht des Leiterplattenfortsatzes 7. Auf der Leiterplattenschicht 14 sind elektrischen Leiterbahnen 15 gebildet. Diese verbinden die Kontaktflächen 11 mit elektronischen Bauelementen 16 und 17 im Innern des Gehäuseabschnitts 5. Auf die Leiterplattenschicht 14 und auf den darauf angeordneten Leiterbahnen 15 ist eine Abdeckschicht 19 aus Leiterplattenmaterial aufgebracht. Die Abdeckschicht 19 bedeckt die Leiterplattenschicht 14 insbesondere im Bereich des Leiterplattenfortsatzes 7, der im Innern der Hydraulikeinheit angeordnet ist. Im Außenbereich, jenseits der Durchführung 10, steht die Leiterplattenschicht 14 unter der Abdeckschicht 19 vor, so dass am Kontaktabschnitt 9 die Kontaktflächen 11 zugänglich sind.

Auf der Abdeckschicht 19 sind weitere Leiterplattenschichten 20, 21, 22 und 23 aufgebracht. Die Leiterplattenschicht 20 dient als Abstandshalter und besitzt, wie die Leiterplattenschicht 19 auch, eine Ausnehmung, in der das Bauelement 16 angeordnet ist. Die Leiterplattenschicht 21 verschließt den durch die Ausnehmungen gebildeten Hohlraum. Der Hohlraum ist mit einer Vergussmasse 25 gefüllt. Dadurch lässt sich die Stabilität des Aufbaus erhöhen und die thermische Anbindung des Bauelements 16 an die umgebenden Leiterplattenschichten verbessern. Die Leiterplattenschicht 21 trägt eine weitere Beschaltung aus Leiterbahnen 27 und dem Bauelement 1.7. Ein quer zum Schichtaufbau verlaufender elektrischer Leiter 28 verbindet Leiterbahnen 15 auf der Schicht 14 und Leiterbahnen auf der Schicht 21. Die Leiterplattenschicht 22 besitzt eine Ausnehmung zur Aufnahme des Bauelements 17. Der so gebildete Hohlraum ist durch die oberste Leiterplattenschicht 23 abgedeckt.

Die Leiterplattenschichten 12 und 23 tragen keine Beschaltung, sondern dienen im dargestellten Ausführungsbeispiel als Abdeckung und als Trägerschicht. Die Leiterplattenschichten 12 und 23 könnten jedoch durchaus auch eine Beschaltung tragen, sofern diese nur auf der nach innen gewandten Oberfläche angeordnet ist. Ferner besitzt die Beschaltung einen gewissen Abstand zum seitlichen Rand des Gehäuseabschnitts 5, so dass der Gehäuseabschnitt 5 von außen gesehen eine dichte, und insoweit homogene Oberfläche besitzt, als das diese nur Leiterplattenmaterial, aber weder Beschaltungselemente noch Leiterbahnen aufweist.

Das Leiterplattenmaterial kann auf Epoxydharz basieren. Dies erlaubt es, einzelnen Leiterplattenschichten 12, 14, 19, 20 bis 23 nacheinander aufeinander aufzubringen und auszuhärten. In Zwischenschritten können jeweils die Leiterbahnen 15 bzw. 27 aufgebracht und die Bestückung vorgenommen werden. Wird zur Verstärkung ein Glasfasermaterial verwendet, werden die in der Außenfläche liegenden Enden der Glasfasern durch eine weitere Schicht abgedeckt, damit kein Druckmittel entlang der Glasfasern in die elektronische Baueinheit 1 eindringt. Dazu kann wiederum Epoxydharz verwendet werden.

Anstatt die Leiterplattenschichten nacheinander aufeinander aufzubringen und auszuhärten können auch einzelne Leiterplattenschichten vorgefertigt werden, ggf. einschließlich ihrer Beschaltung, und in einem abschließenden Arbeitsgang miteinander verklebt werden. Dazu kann ebenfalls ein Epoxydharzmaterial verwendet werden. Weisen die Bauelementen 16 und 17 nur eine geringe Bauhöhe auf, so lassen sie sich in die Klebeschicht einbetten. Insbesondere eignen sich zu diesem Zweck SMD-Bauelemente.

Bei Verwendung von Epoxydharz als Leiterplattenmaterial ist der Leiterplattenfortsatz 7 bei geringer Materialstärke hinreichend flexibel, um eine kabelartige Verlegung zuzulassen. Anstatt aus Epoxydharz können die Leiterplattenschichten auch aus einem anderen Leiterplattenmaterial, z.B. Polyimidfolie, hergestellt sein. Insbesondere für die Leiterplattenschichten 14 und 19, die in den Leiterplattenfortsatz 7 übergehen, ist ein solches Material vorteilhaft, wobei die Kompatibilität der Materialen zueinander bezüglich der Verklebungen mit den angrenzenden Leiterplattenschichten 12 und 20 gewährleistet sein muss. Dadurch erhält man einen nochmals flexibleren, kabelartig verlegbaren und gleichzeitig reißfesten Leiterplattenfortsatz 7. Es ist auch durchaus möglich, die Leiterplattenschichten 12 und 20 bis 23, die über den Gehäuseabschnitt 5 nicht hinausgehen, aus einem Epoxydharzmaterial herzustellen, und die Leiterplattenschichten 14 und 19, die den Leiterplattenfortsatz 7 bilden, aus Polyimidfolie herzustellen, und die Schichten aus unterschiedlichen Leiterplattenmaterial miteinander zu verkleben. Der Leiterplattenfortsatz 7 kann auch mehr als 2 Leiterplattenschichten aufweisen, falls eine höhere Biegesteifigkeit und Festigkeit gewünscht ist. Außerdem kann ein Teil der Beschaltung im Leiterplattenfortsatz 7 angeordnet sein, und der Gehäuseabschnitt 5 entsprechend kleiner ausgebildet sein.

Da die Leiterplattenschichten mit Ausnahme etwaiger Hohlräume für Bauelemente vollflächig chemisch miteinander verbunden bzw. verklebt sind, kann die elektronische Baueinheit 1 zumindest in Bereichen ohne Beschaltung nachträglich mechanisch bearbeitet werden, ohne die Dichtigkeit zu beeinträchtigen. So können z.B. Einbuchtungen 35 zur Aufnahme von Schraubenköpfen, Bohrungen, etc. gefertigt werden. Bei Herstellung einzelner Leiterplattenschichten können diese jedoch auch in entsprechender Form ausgestanzt werden. Auf diese Weise lassen sich auch die Hohlräume zur Aufnahme der Bauelemente 16 und 17 einfach ausbilden.

### Bezugszeichenliste

- 1: Elektronische Baueinheit
- 2: Unterlage
- 3: Schrauben
- 4: Gehäusewand
- 5: Gehäuseabschnitt
- 7: Leiterplattenfortsatz
- 9: Kontaktabschnitt
- 10: Durchführung
- 11: Kontaktflächen
- 12: Trägerschicht
- 14: Leiterplattenschicht
- 15: Leiterbahnen
- 16: elektronisches Bauelement
- 17: elektronisches Bauelement
- 19: Abdeckschicht
- 20: Leiterplattenschicht
- 21: Leiterplattenschicht
- 22: Leiterplattenschicht
- 23: Leiterplattenschicht
- 25: Vergussmasse
- 27: Leiterbahnen
- 28: elektrischer Leiter
- 30: Verdickung
- 31: Verdickung
- 33: Dichtelement
- 35: Einbuchtung

## Patentansprüche

1. Elektronische Baueinheit, insbesondere zum Einsatz in einem ölgefüllten bzw. druckbeaufschlagten Innenraum einer Hydraulikeinheit, mit einer Leiterplatte, mit einer Beschaltung (15, 16, 17, 27, 28) der Leiterplatte, die Leiterbahnabschnitte (15, 27, 28) und in einem Gehäuseabschnitt (5) der Leiterplatte angeordnete elektronische Bauelemente (16, 17) umfasst, und mit einem Leiterplattenfortsatz (7), der an einem dem Gehäuseabschnitt (5) abgewandten Kontaktabschnitt (9) elektrische Kontaktflächen (11) aufweist, wobei die Beschaltung (15, 16, 17, 27, 28) der Leiterplatte durch Leiterplattenmaterial (19, 23) flüssigkeitsdicht abgedeckt ist.

2. Elektronische Baueinheit nach Anspruch 1, **dadurch gekennzeichnet, dass** die Leiterplatte mehrere übereinander aufgebrachte Leiterplattenschichten (12, 14, 19, 20, 21, 22, 23) aufweist.

3. Elektronische Baueinheit nach Anspruch 2, **dadurch gekennzeichnet, dass** die Leiterplattenschichten (12, 14, 19, 20, 21, 22, 23) miteinander verklebt sind.

4. Elektronische Baueinheit nach Anspruch 2 oder 3, **dadurch gekennzeichnet, dass** der Leiterplattenfortsatz (7) mittels zweier übereinander angeordneter Leiterplattenschichten (14, 19) der Leiterplatte gebildet ist.

5. Elektronische Baueinheit nach einem der Ansprüche 2 bis 4, **dadurch gekennzeichnet, dass** Leiterplattenschichten (14, 19) im Leiterplattenfortsatz (7), eine Polyesterfolie, insbesondere eine Polyimidfolie umfassen.

6. Elektronische Baueinheit nach einem der vorhergehenden Ansprüche, **dadurch gekennzeichnet, dass** in der Leiterplatte angeordnete Einlagen, insbesondere eine Glasfaserverstärkung, eine abdeckende Beschichtung an einer Außenseite der elektronischen Baueinheit aufweisen.

7. Elektronische Baueinheit nach einem der vorhergehenden Ansprüche, **dadurch gekennzeichnet, dass** die Beschaltung (15, 16, 17, 27) der Leiterplatte einen berührungslos arbeitenden Sensor, insbesondere einen Hallsensor, einen kapazitiven Annäherungssensor, einen optischen Sensor oder einen induktiv arbeitenden Sensor umfasst.

8. Elektronische Baueinheit nach einem der vorhergehenden Ansprüche, **dadurch gekennzeichnet, dass** mittlere Leiterplattenschichten (20, 22) Aussparungen aufweisen, in denen elektronische Bauelemente (16, 17) aufgenommen sind.

9. Elektronische Baueinheit nach einem der vorhergehenden Ansprüche, **dadurch gekennzeichnet, dass** der Leiterplattenfortsatz (7) an einem Durchführungsabschnitt eine aus Leiterplattenmaterial gebildete Verdickung (30, 31) aufweist.
